# EUROPEAN PATENT APPLICATION

(11) **EP 3 176 888 A1**
(43) Date of publication of application: **07.06.2017**
(21) Application number: 15197840.0
(22) Date of filing: 03.12.2015
(51) Int. Cl.: H01S 5/00, H01S 5/026, H01L 31/153, H01S 5/183, H01L 31/0304, H01L 31/105, H01L 31/18, H01S 5/022

(54) **SENSOR CHIP**

(71) Applicant: Koninklijke Philips N.V., 5656 AE Eindhoven (NL)
(72) Inventor: The designation of the inventor has not yet been filed
(74) Representative: de Haan, Poul Erik

(57) **Abstract**

The invention relates to a sensor chip (200) which is especially suited for time-of-flight measurements. The sensor chip (200) comprises one or more lasers and photodetectors which are arranged next to each other on the same semiconductor substrate. The lasers or laser structures (100) and photodetectors of photodetector structures (150) are processed on the same wafer in the same processing steps. The variations between the structures of the lasers and photodetectors can therefore be minimized. The resonant photodetectors are arranged to be sensitive in the wavelength range in which the lasers emit laser light. The optical passband of the resonant photodetectors is broader than the optical passband of a laser cavity of the lasers. Variations of the emission wavelengths of the laser light which may, for example, be caused by temperature differences between the light emitting laser and the resonant photodetector can therefore be compensated. The invention further relates to a sensor module (300) comprising such a sensor chip (200) and the method of manufacturing the sensor chip (200).

## Description

### FIELD OF THE INVENTION

The invention relates to a sensor chip, a sensor module comprising such a sensor chip and the method of fabricating the sensor chip.

### BACKGROUND OF THE INVENTION

Lasers especially Vertical Cavity Surface Emitting Lasers (VCSEL) or VCSEL arrays can be used as infrared illumination device. Using short pulses they are applied in time of flight applications. Such applications comprise e.g. short-range gesture recognition for portable devices, mid-range LIDAR for e.g. industry automation, robotics, as user interface for lighting installations as well as long-range LIDAR in automotive. A typical system consists of the VCSEL module mounted on a board, an electronic driver (mostly on the same board), optics (which may include e.g. a MEMS scanning mirror and beam shaping optics) and usually two photo-detectors. The driver supplies a short current pulse (1-20 ns) to the VCSEL which emits laser light eventually after a short time delay. Preferably, the "outgoing" laser light or pulse is detected by a first photodetector and defines a time t1. Laser light scattered or reflected back from an object in the scene is preferably detected by an independent second photodetector at a later time t2 and the time of flight t= t2-t1 defines the distance to the object. The first photodetector is in most cases a pin photodiode made from silicon. The second photodetector is preferably a single photon avalanche diode.

### SUMMARY OF THE INVENTION

It is an object of the present invention to provide an improved sensor chip. The sensor chip may preferably be used for time of flight measurements.

According to a first aspect a sensor chip is provided. The sensor chip comprises a semiconductor layer structure. The semiconductor layer structure comprises at least one laser structure deposited on a substrate. The semiconductor layer structure further comprises at least one photodetector structure deposited on the substrate adjacent to the at least one laser structure. The at least one laser structure comprises a laser cavity with a laser emission mirror for emitting laser light. The at least one photodetector structure comprises a photodetector layer for detecting at least a part of the emitted laser light. The at least one photodetector structure comprises a filter structure. The filter structure comprises a first optical passband comprising an emission wavelength of the laser structure, and wherein the first optical passband comprises a broader wavelength range as a second optical passband of the laser cavity of the at least one laser structure. The photodetector layer is preferably placed in an anti-node of the standing wave in the resonant filter structure.

The term "layer" does not exclude that the layer comprises two or more sublayers. The optical passband is defined as a wavelength range within which the intensity received within the respective resonant structure is enhanced at the position of the photodetector layer with respect to the intensity at the outer surface. The passband depends on the quality factor of the resonant structure. The passband gets narrower if the quality factor increases. The laser structure and the photodetector structure may be directly deposited on the substrate or there may be one or more intermediate layers. The laser structure may preferably be arranged as Vertically Cavity Surface Emitting Laser (VCSEL). The part of the emitted laser light which can be detected by the photodetector layer may be directly received from the laser structure or indirectly received after reflection at a reflection structure or at an object. Laser light which maybe directly received or received from a nearby reflection structure (e.g. part of an optical device) maybe used to determine a time t1 of emission of the laser light by means of the laser structure. Laser light which maybe received from the object may be used to determine a time t2 wherein the time of flight t= t2-t1 can be used to determine the distance to the object in the applications described above.

The photodetector structure comprises a resonant filter structure. The quality factor of this filter structure is lower than a quality factor of the laser cavity. The photodetector is arranged such that laser light emitted by the laser structure is amplified within the resonant filter structure. The lower quality factor in comparison to the laser cavity has the effect that variations of the wavelengths of the emitted laser light can still be received within the resonant filter structure. Small variations of the wavelengths of the emitted laser light which may be caused, for example, by temperature differences can therefore be compensated. The passband of the filter structure is preferably arranged such that the wavelength of a short pulse of the emitted laser light (essentially no heating of the laser) is near to the center of the passband of the filter structure.

The laser cavity comprises preferably a first laser mirror, a second laser mirror and an active laser layer embedded between the first laser mirror and the second laser mirror. The second laser mirror is preferably arranged as the laser emission mirror. The at least one photodetector structure comprises a first photodetector mirror, a second photodetector mirror and a first photosensitive layer embedded between the first photodetector mirror and the second photodetector mirror. The at least one laser structure further comprises a first electrical contact and a second laser contact. The at least one photodetector structure comprises a first photodetector electrode and a second or third photodetector electrode.

The first electrode and the first photodetector electrode maybe arranged as one common electrode at a bottom surface of the substrate (averted surface with respect to the semiconductor layer structure comprising the laser structure and the photodetector structure). The first electrode and the first photodetector electrode may alternatively be separate electrodes which are not electrically connected. Separation of the first electrode and the first photodetector electrode may improve isolation between the laser structure and the photodetector structure in order to limit cross talk. The photodetector structure may comprise a second and a third photodetector electrode, only a second photodetector electrode or only a third photodetector electrode.

The filter structure may comprise the first photodetector mirror, the first photosensitive layer and the second photodetector mirror, wherein a reflectivity of the second photodetector mirror is reduced in comparison to a reflectivity of the laser emission mirror, and wherein the first photosensitive layer is arranged as the photodetector layer.

The first photodetector mirror, the photosensitive layer and the second photodetector mirror may comprise the same layer sequence as the first laser mirror, the active laser layer and the second laser mirror. The layers of the first photodetector mirror and the first laser mirror, the first photosensitive layer and active laser layer as well as the second photodetector mirror and the second laser mirror are in this case deposited in the same production steps. The emission frequency of the laser structure automatically matches a center frequency of the passband of the filter structure because both are produced in the same production process.

The second photodetector mirror may alternatively comprise at least a part of the semiconductor layer structure comprising the first laser mirror. The first photosensitive layer and the first photodetector mirror may in this case be deposited between the substrate and the first laser mirror. The photodetector structure and the laser structure maybe produced in the same production steps but a part of the deposited layers may be removed at the position of the photodetector structure in order to build the photodetector structure. The first photodetector mirror and the first laser mirror as well as the first photosensitive layer and the active laser layer are in this case not manufactured in the same production steps but in the same production process.

The second photodetector electrode is in this case preferably arranged on top of the second photodetector mirror meaning the side of the second photodetector mirror which is averted from the first photosensitive layer.

The reduction of the reflection of the second photodetector mirror in comparison to the reflectivity of the laser emission mirror (second laser mirror) reduces the quality factor of the resonant cavity comprising the photodetector layer in order to increase the passband of the filter structure.

The second photodetector mirror is according to one embodiment characterized by a layer sequence which is the same as a layer sequence of the laser emission mirror. The photodetector structure further comprises a second photosensitive layer and a third photodetector mirror which is embedded between the second photodetector mirror and the third photodetector mirror. The third photodetector electrode faces a second surface of the third photodetector mirror. The second surface of the third photodetector mirror is averted from the second photosensitive layer. The second photosensitive layer is arranged as the photodetector layer. The filter structure comprises the second photodetector mirror, the second photosensitive layer and the third photodetector mirror.

The photodetector structure and the laser structure are produced within the same production steps. The second photosensitive layer and said photodetector mirror are also deposited on top of the laser structures but removed in a subsequent processing step.

The filter structure may further comprise the first photodetector mirror and the first photosensitive layer.

The reflectivity of the second photodetector mirror may be reduced by providing at least one additional layer in comparison to the laser emission mirror.

The additional layer may, for example, comprise the same material as the top layer of the laser emission mirror. The total thickness of the top layer of the second photodetector mirror may in this case be increased to □/2 of the emission wavelengths of the laser structure in order to reduce reflectivity of the second photodetector mirror and therefore reduce the quality factor of the filter structure. An alternative approach may be to add dielectric mirror layers which are arranged in anti-phase with respect to the semiconducting layers of the second photodetector mirror. The additional layer or layers may be removed by means of, for example, etching in a subsequent step.

The reflectivity of the second photodetector mirror may alternatively be reduced by removing at least a part of a layer in comparison to the laser emission mirror.

The second photodetector mirror and the second laser mirror may be deposited in the same processing steps. The second photodetector electrode may be deposited and a part of the layer or layers of the second photodetector mirror maybe etched. Alternatively, a part of the layer or layers of the second photodetector mirror maybe removed and the second photodetector electrode may be deposited in a subsequent step in which preferably also the second laser contact or electrode is deposited.

The sensor chip as described above or below may comprise an absorption structure. The absorption structure may be arranged such that a direct light transmission between the at least one laser structure and the at least one photodetector structure is inhibited.

A trench between the at least one mesa comprising the laser structure (VCSEL structure) and the at least one mesa comprising the photodetector structure may be filled with metal in order to inhibit direct light transmission between the laser structure and the photodetector structure.

The filter structure may in one embodiment comprise the third photodetector mirror, the second photosensitive layer and the second photodetector mirror as described above. The at least one photodetector structure may in this case further comprise the second photodetector electrode. The second photodetector electrode faces a second surface of the second photodetector mirror averted from the first photosensitive layer. The second photodetector electrode may be electrically connected to the first photodetector electrode such that absorption of the first photosensitive layer is increased.

Optical decoupling between laser structure and the photodetector structure is enabled or improved in this embodiment by means of the short circuit of the first and the second photodetector electrode. The short circuit removes charge carriers which maybe generated by means of optical cross talk between the laser structure and the detector structure.

The sensor chip as described above may comprise two, three, four or more of laser structures. The sensor chip may comprise less photodetector structures in comparison to the number of laser structures.

The photodetector layer within the filter structure of the photodetector structure maybe used as trigger diode. As more than enough light is available at t1 the size of the photodetector structure can be small (small and single mesa) and a compromise in quantum efficiency by the placement and thickness of the photodetector layer is easily acceptable.

The sensor chip may comprise two, three, four or more photodetector structures. At least a part of the photodetector structures may be arranged such that a detection of laser light emitted by the at least one laser structure and reaching the photodetector structure at the time of emission is inhibited.

One or more photodetector structure may be optically isolated by means of an absorption structure as described above. Furthermore, the one or more photodetector structure may be placed such that laser light emitted by the at least one laser structure cannot be received before being reflected at an external object. The distance between the one or more photodetector structure and the at least one laser structure may, for example, be that big that the one or more photodetector structure can be optically isolated with respect to at least one laser structure. The one or more photodetector structure may in this case be used for the detection of reflected or backscattered light. In this case it is desirable to optimize the sensitivity of the photodetector structure to choose for an ideal vertical placement (resonance enhancement) and to make it relatively large (or use many photodetector structures in order to make it also fast). A separate electrical contact and amplifier maybe needed in a sensor module comprising such a sensor chip in order to allow high sensitivity a short time after t1. Exposure to the primary laser pulse at t1 as this would blind the one or more photodetector structure for a certain time may further be avoided or at least reduced by taking into account substrate reflections (removed or blackened) as well as a careful design of the optics in order to avoid unwanted reflections. The optical isolation is especially simple in case of an emission below 860nm. In this case the GaAs substrate is strongly absorbing.

The sensor chip may comprise two, three, four or more laser structures. The sensor chip may further comprise two, three, four or more photodetector structures. A sum of laser light emitting areas of the laser structures is smaller than a sum of laser light receiving areas of the photodetector structures.

A laser light emitting area of the laser structure may be defined by means of an aperture through which laser light is emitted. Such an aperture may be defined by means of an opening in a layer which is oxidized during production of the laser or laser structure and/or an electrode for contacting the laser. Such a laser is preferably a VCSEL. The receiving area of the photodetector structure is defined by the area of the photodetector layer which can be exposed to laser light received by means of the photodetector structure. The receiving area of the photodetector structure maybe limited by means of an aperture similar as the laser structure and/or by means of an electrode to contact the photodetector structure. Each laser structure and each photodetector structure may comprise a separate mesa. A mesa of a photodetector structure may preferably have a bigger diameter in comparison to a diameter of a mesa of a laser structure. Alternatively or in addition, there may be more photodetector structures in comparison to a number of laser structures wherein both may have the same size (e.g. diameter of the respective mesa).

The photodetector layer may comprise a photosensitive GaAs or GaInNAs layer with a thickness of at least 5 nm, more preferably with a thickness of at least 15 nm and most preferably with a thickness of at least 30 nm.

The photosensitive GaAs or GaInNAs layer may be arranged as first photosensitive layer or second photosensitive layer. A conventional quantum well layer which may be used as active laser layer in combination with decreased quality factor of the resonant structure comprising the photosensitive layer by removing or reducing, for example, a part of mirror layers of the second or third photodetector mirror may be not sufficiently sensitive in order to detect laser light which is reflected from an external object. This reflected laser light is used to determine the time t2 which is needed to determine the time of flight of the reflected laser light in order to determine the distance to the external object. A relatively thick photosensitive GaAs or GaInNAs bulk layer which can also be used within a laser cavity as active laser layer may in this case be beneficial. The higher "one pass" absorption meaning the absorption when the laser light passes the bulk layer only one time enables sufficient sensitivity of the photosensitive layer even in case of a resonator with a low quality factor or to phrase it in a different way with a broad optical passband. The thickness of the layer is an essential parameter in order to provide sufficient "one pass" absorption. A thickness of at least 20 nm or even 40 nm or 50 nm may therefore be preferred. The thickness maybe limited by the extension of the anti-node of the standing wave for resonance enhancement. Furthermore, the laser threshold current becomes larger for thicker layers. This may be important in cases in which a thick bulk layer is also comprised by the active layer of the laser structure.

According to a further aspect a sensor module is provided. The sensor module comprises at least one sensor chip according to any embodiment as described above. The sensor module further comprises a laser driving circuit, a photodetector circuit and an optical device. The electrical driving circuit is arranged to electrically drive the at least one laser structure. The photodetector circuit is arranged to electrically drive the at least one photodetector structure. The optical device is arranged to transmit laser light emitted by the at least one laser structure to an object and to transmit laser light reflected from the object to the photodetector structure. The object is arranged external with respect to the sensor module.

The laser driving circuit is configured to provide the electrical power to the at least one laser structure which is needed to emit laser light to the object. The photodetector circuit may be arranged to provide a bias voltage to the photodetector structure and/or to receive measurement signals from the photodetector structure and to amplify such measurement signals. The laser driving circuit and the photodetector circuit may be arranged in different units (e.g. chips) or be integrated within one unit (e.g. one chip or ASIC).

The at least one photodetector structure may comprise a first photodetector electrode, a second photodetector electrode and a third photodetector electrode. The photodetector circuit maybe arranged to receive a first photo current between the first photodetector electrode and the second photodetector electrode. The photodetector circuit may be further arranged to receive a second photo current between the second photodetector electrode and the third photodetector electrode. The photodetector circuit is arranged to amplify a difference between the second photo current and the first photo current.

Taking the difference between the second photo current and the first photo current (or vice versa) may help to avoid saturation of the amplifier of the photodetector circuit by the high initial laser pulse and helps to use the same photodetector structure also for the high sensitivity detection laser light back reflected from the object in the scene. A bias voltage provided by means of the photodetector circuit to the first photodetector electrode and the second photodetector electrode may be used to fine-tune the sensitivity of the photodetector structure.

The sensor module may be arranged to reflect at least a first part of the laser light emitted by the at least one laser structure to the at least one photodetector structure such that a time of emission of the laser light emitted by the at least one laser structure can be detected by means of the at least one photodetector structure.

The optical device of the sensor module may, for example, comprise a reflection structure which is arranged to reflect laser light emitted by means of the at least one laser structure shortly after the time of emission to the at least one photodetector structure. The distance between the laser structure, the reflection structure and the photodetector structure has to be that short that the time of emission and the time of receiving light reflected by means of the reflection structure or any other corresponding arrangement within the sensor module are nearly identical.

Alternatively, the sensor chip comprised by the sensor module may be arranged such that, for example, laser light generated by means of at least one laser structure is guided, for example, by means of the substrate to at least one photodetector structure in order to determine the time of emission of the laser light. Especially for longer wavelengths there can be strong guiding via the substrate. A backside structuring may be added in order to get more light towards neighboring mesas.

The sensor module may according to one embodiment comprise a separate photodetector. The separate photodetector may be arranged to receive at least a second part of the laser light emitted by the at least one laser structure. The second part of the laser light is reflected by the object external with respect to the sensor module.

The most direct approach is to use the at least one photodetector structure as trigger diode. As more than enough light is available at t1 the size of the photodetector structure can be small (small and single mesa) and a compromise in quantum efficiency by the placement and thickness of the photodetector layer is easily acceptable.

A specific separate photodetector may be provided and integrated in the sensor module for detecting the backscattered light (e.g. light reflected by the object). In this case it is desirable to optimize the sensitivity of the separate photodetector i.e. to choose for an ideal vertical placement (resonance enhancement) and to make it relatively large (or use a photodetector with many photosensitive areas optionally integrated on one separate chip in order to make it also fast). A separate electrical contact and amplifier is needed in order to allow high sensitivity a short time after t1. The separate photodetector must not be exposed to the primary laser pulse at t1 as this would blind it for a certain time. Therefore a separate chip (but preferably from the same wafer and wafer area) in order to eliminate manufacturing tolerances) can be advantageous.

If the laser structure and two types of photodetector structures (one for measuring t1 and one for measuring t2) should be on one chip (especially for low cost consumer products) measures have to be foreseen in order to protect the photodetector structure for measuring t2 from direct laser light. Such measures should take into account substrate reflections (removed or blackened) as well as a careful design of the optics in order to avoid unwanted reflections to the photodetector structure for measuring t2.

The sensor module may further comprise an analyzer. The analyzer is arranged to determine a distance to the object based on measurement signals received from the at least one photodetector structure and/or the photodetector circuit and optionally driving signals received from the electrical driving circuit.

The analyzer may comprise the photodetector circuit.

The sensor chip and sensor module may have an additional advantages on system level if separate detection channels work at different wavelengths because the spectral selectivity can be very high and therefore signals from other channels are efficiently suppressed. Different detection channels can e.g. cover different parts of the angular space or remove ambiguities.

According to a further aspect a method of fabricating a sensor chip is provided. The method comprising the steps of:
- providing a first electrical contact,
- providing a substrate,
- providing a at least one laser structure on the substrate, wherein the at least one laser structure comprises a laser cavity with a laser emission mirror for emitting laser light,
- providing at least one photodetector structure on the substrate adjacent to the at least one laser structure, wherein the at least one photodetector structure comprises a photodetector layer for detecting laser light, and wherein the at least one photodetector structure comprises a filter structure for receiving reflected laser light,
- adapting a first optical passband of the filter structure, such that the first optical passband comprises a broader wavelength range as a second optical passband of the laser emission mirror of the laser structure, wherein the first optical passband comprises the emission wavelength of the at least one laser structure.

The method steps need not necessarily be performed in the order given above. The first electrical contact may, for example, be provided in a later step if there is no common electrode for contacting the at least one laser structure and the at least one photodetector structure (see description below).

It shall be understood that the sensor chip according to claims 1 - 9, the sensor module according to claims 10 - 14 and the method according to claim 15 have similar and/or identical embodiments, in particular, as defined in the dependent claims.

It shall be understood that a preferred embodiment of the invention can also be any combination of the dependent claims with the respective independent claim. The features of claim 9 may, for example, be combined with the features of claims 7 or 8.The features of claim 14 may, for example, be combined with the features of any one of the claims 10 - 13.

Further advantageous embodiments are defined below.

### BRIEF DESCRIPTION OF THE DRAWINGS

These and other aspects of the invention will be apparent from and elucidated with reference to the embodiments described hereinafter.

The invention will now be described, by way of example, based on embodiments with reference to the accompanying drawings.

In the drawings:
Fig. 1 shows a principal sketch of a cross-section of a first sensor chip
Fig. 2 shows a principal sketch of a cross-section of a second sensor chip
Fig. 3 shows a principal sketch of a cross-section of a third sensor chip
Fig. 4 shows a principal sketch of a cross-section of a fourth sensor chip
Fig. 5 shows a principal sketch of a top view of a fifth sensor chip
Fig. 6 shows a principal sketch of a top view of a sixth sensor chip
Fig. 7 shows a principal sketch of a top view of a seventh sensor chip
Fig. 8 shows a principal sketch of a top view of an eigth sensor chip
Fig. 9 shows a principal sketch of a first sensor module
Fig. 10 shows a principal sketch of a second sensor module
Fig. 11 shows a principal sketch of a method of fabricating a sensor chip

In the Figures, like numbers refer to like objects throughout. Objects in the Figures are not necessarily drawn to scale.

### DETAILED DESCRIPTION OF EMBODIMENTS

Various embodiments of the invention will now be described by means of the Figures.

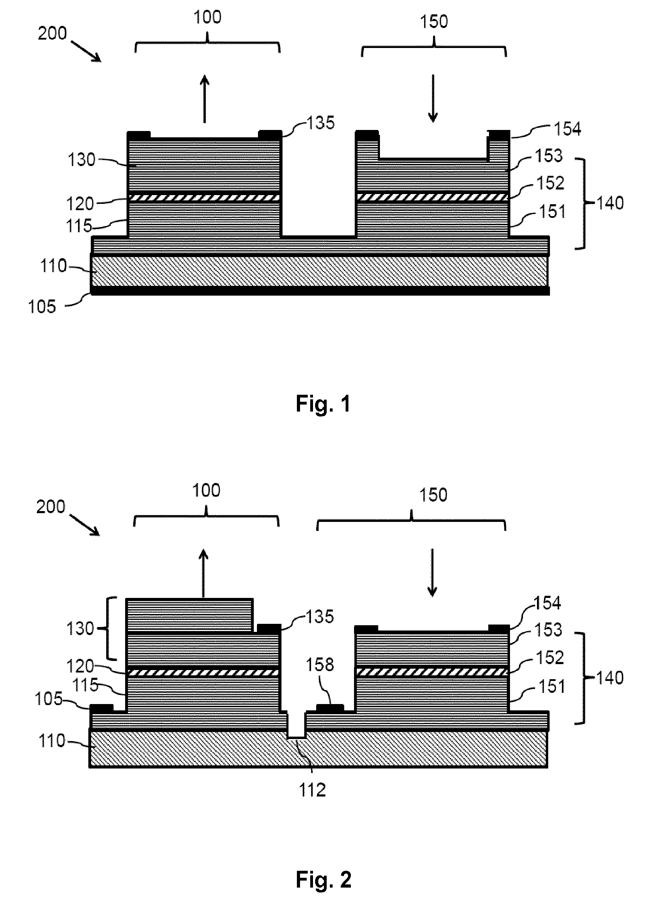

Fig. 1 shows a principal sketch of a cross-section of a first sensor chip 200. The first sensor chip 200 comprises a substrate 110. A first electrode 105 is provided or deposited on a first side of the substrate 110. Optionally one or more supporting layers may be provided between the substrate 110 and the first electrode 105. A first mirror structure is either directly or indirectly (e.g. intermediate matching layers) provided on a second surface of the substrate 110. The first mirror structure comprises in this embodiment layers of a first laser mirror 115 and a first photodetector mirror 151. The layers are deposited in the same production steps and a part of the layers are separated from each other in a subsequent etching step. On top of the first mirror structure or on intermediate matching layers are, for example, three, four or more quantum well layers provided. A first part of the quantum well layers forms an active laser layer 120 and the second part a first photosensitive layer 152 which are separated from each other in a subsequent etching step. On top of the quantum well layers or on intermediate matching layers is a second mirror structure provided. A first part of the second mirror structure forms a second laser mirror 130 and a second part a second photodetector mirror 153 which are separated from each other in a subsequent etching step. The first photodetector mirror 151, the first photosensitive layer 152 and the second photodetector mirror 153 define the filter structure 140 and in this embodiment a photodetector structure 150. The first laser mirror 115, the active laser layer 120 and the second laser mirror 130 define a laser cavity of a laser structure 100. The second laser mirror 130 is in this case arranged as laser emission mirror. The laser structure 100 is arranged as top emitting VCSEL emitting laser light away from the substrate 110 as indicated by the arrow. The laser structure 100 further comprises a second laser contact 135 which is provided or deposited on top of the second mirror structure. The photodetector structure 150 comprises a second photodetector electrode 154 which is also provided or deposited on top of the second mirror structure. Optionally, additional matching layers and/or electrical current spreading layers may be provided between the second mirror structure and the electrically conductive layer which is structured to build the second laser contact 135 and the second photodetector electrode 154. The laser structure 100 comprises a first mesa and the photodetector structure 150 comprises a second mesa both are etched within the same etching step or steps. Some layers of the second mirror structure which comprises second photodetector mirror 153 are removed such that a reflectivity of the second photodetector mirror 153 is lower than a reflectivity of the second laser mirror 130. The photodetector structure 150 receives reflected laser light via the second photodetector mirror 153 as indicated by the arrow. A quality factor of the resonant filter structure 140 is therefore lower than a quality factor of the laser cavity. The laser structure 100 may in this case be arranged to emit, for example, laser light at a wavelength of 850 nm. The full width at half maximum (FWHM) of the emitted laser light is 2 nm. The reflectivity of the second photodetector mirror 153 or the quality factor of the resonant filter structure is reduced such that the full width at half maximum of laser light received in the filter structure is 10 nm wherein the center frequency is at 850 nm. The broader passband of the filter structure enables therefore compensation of, for example, thermal shifts of the wavelengths of the emitted laser light which may be caused by temperature differences between the laser structure 100 (electrical power provided to emit laser light) and the photodetector structure 150. The photodetector structure 150 is therefore arranged to receive laser light at a wavelengths of, for example, 853 nm with sufficiently high intensity. The first electrical contact 105 is in this case arranged as a common electrical contact for the laser structure 100 and the first photodetector structure 150. The first electrical contact 105 comprises in this case the first laser contact and a first photodetector electrode.

Fig. 2 shows a principal sketch of a cross-section of a second sensor chip 200. The general structure of the second sensor chip 200 is similar to the first sensor chip 200 shown in Fig. 1. The second sensor chip 200 comprises again a first mirror structure and the second mirror structure which are arranged to form the first laser mirror 115, the photodetector mirror 151 respectively at least a part of the second laser mirror 130 and the second photodetector mirror 153. Instead of a quantum well layer a photosensitive bulk layer of gallium arsenide with a thickness of 50 nm is provided. The bulk layer of gallium arsenide is structured as described above with respect to the quantum well layer such that a first part forms the active laser layer 120 and a second part forms the first photosensitive layer 152. Instead of one common bottom electrode a separate first electrical contact 105 is provided to contact the laser structure 100 and a separate first photodetector electrode 158 is provided to contact the photodetector structure 150. Electrical and optical isolation between the mesa of the laser structure 100 and the mesa of the photodetector structure 150 is improved by means of a trench 112 between the laser structure 100 and the photodetector structure 150. Electrical insulation can be further improved using a semi-insulating substrate 110. The second laser mirror 130 comprises a first part of semiconductor layers with different refractive index (e.g. AlGaAs layers with different aluminum content) and a second part of dielectric layers with alternating refractive index (e.g. comprising SiO₂, Si₃N₄, TiO₂ ...). The second part of dielectric layers maybe either selectivity provided only as part of the laser structure 100 or alternatively it may be provided as part of the laser structure 100 and the photodetector structure 150 but subsequently removed such that the second photodetector mirror 153 comprises only semiconductor layers with different refractive index. The additional dielectric layers increase the reflectivity of the second laser mirror 130 such that the spectral selectivity of the photodetector structure 150 is less than the spectral selectivity of the laser cavity of the laser structure 100. Or to rephrase it the quality factor of the laser cavity is again higher as the quality factor of the filter structure 140. The second laser contact 135 is arranged such that there is an electrically conductive connection to the semiconductor layers of the second laser mirror 130. The second photodetector electrode 154 is deposited on top of the top layer of the semiconductor layers of the second photodetector mirror 153.

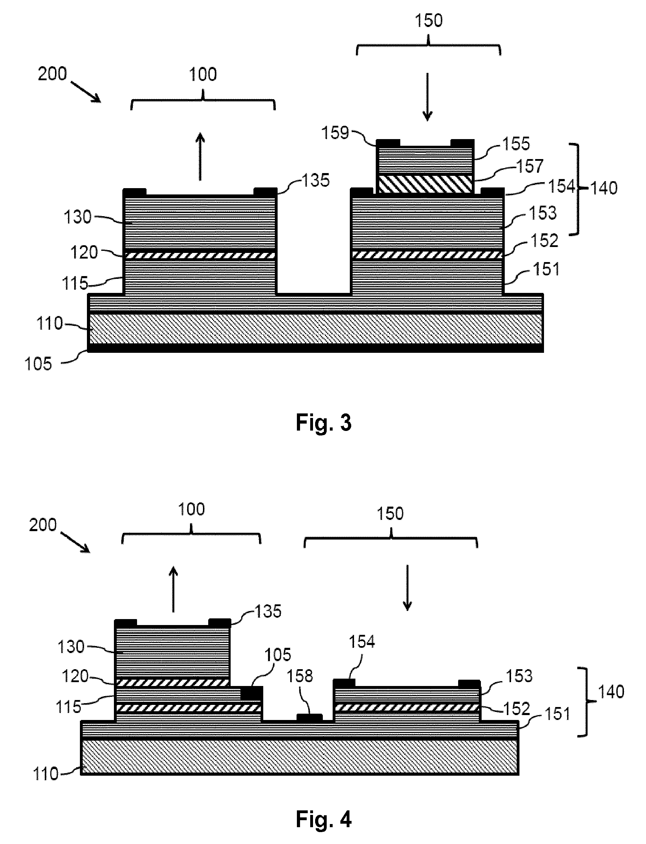

Fig. 3 shows a principal sketch of a cross-section of a third sensor chip 200. The structure of the third sensor chip 200 is up to the etching step of the second photodetector mirror nearly identical to the structure of the first sensor chip 200 shown in Fig. 1. Instead of etching the second photodetector mirror 153 a second photosensitive layer 157 and a third photodetector mirror 155 are provided on top of the second photodetector mirror 153, wherein the second photosensitive layer 157 is embedded between the second photodetector mirror 153 and the third photodetector mirror 155. The second photosensitive layer 157 comprises a bulk layer of GaInNAs with a thickness of 20 nm. The third photodetector mirror 155 is an n-doped Distributed Rack Reflector (DBR) with 10 pairs of layers. The first mirror structure comprises an n-doped DBR with 40 pairs of layers. The second mirror structure comprises an p-doped DBR with 20 pairs of layers. The lower number of DBR layers in the third photodetector mirror 155 increases the optical passband of the filter structure 140 which comprises in this case the second photodetector mirror 153, the second photosensitive layer 157 and the third photodetector mirror 155. A third photodetector electrode 159 is deposited on top of the third photodetector mirror 155 such that the measurement signal can be measured between the second photodetector electrode 154 on top of the second photodetector mirror 153 and the third photodetector electrode 159. The second photodetector electrode 154 can optionally be electrically connected to the first electrical contract 105 at the bottom of the substrate 110 in order to increase absorption of laser light which maybe guided via the substrate 110 in the first photosensitive layer 152 (consisting of the quantum well layers).

Fig. 4 shows a principal sketch of a cross-section of a fourth sensor chip 200. The first sensor chip 200 comprises an n-doped substrate 110. A first mirror structure is either directly or indirectly (e.g. intermediate matching layers) provided on a second surface of the substrate 110. The first mirror structure comprises in this embodiment a DBR of 10 pairs of layers of p-doped semiconductor material. On top of the first mirror structure or on intermediate matching layers is a photosensitive gallium arsenide bulk layer with a thickness of 100 nm provided. A first part of the gallium arsenide layer is arranged within the laser structure 100 and a second part builds a first photosensitive layer 152 within the photodetector structure 150. On top of the gallium arsenide layer or on intermediate matching layers is a second mirror structure provided which comprises a DBR with 40 pairs of n-doped semiconductor layers. A first part of the second mirror structure forms the first laser mirror 115 and a second part the second photodetector mirror 153 which are separated from each other in a subsequent etching step. The first photodetector mirror 151, the first photosensitive layer 152 and the second photodetector mirror 153 define the filter structure 140 and in this embodiment together with a first photodetector electrode 158 electrically connected to the first photodetector mirror 151 and a second photodetector electrode 154 electrically connected to the second photodetector mirror 153 the photodetector structure 150. An active laser layer 120 is provided on top of the second mirror structure and a third mirror structure is provided on top of the active laser layer 120. The active laser layer 120 comprises in this case three quantum well layers. The third mirror structure comprises a DBR with 20 pairs of p-doped semiconductor layers. The third mirror structure and the active laser layer 120 are removed above the second photodetector mirror 153 such that the second photodetector electrode 154 can be deposited on top of the second photodetector mirror 153. A second laser contact 135 is provided on top of the second laser mirror 130 which comprises the part of the third mirror structure which is provided on top of the active laser layer 120 of the laser structure 100. The first electrical contact 105 is electrically connected to the first laser mirror 115 such that the laser structure 100 can be electrically driven by means of the first electrical contact 105 and the second laser contact 135.

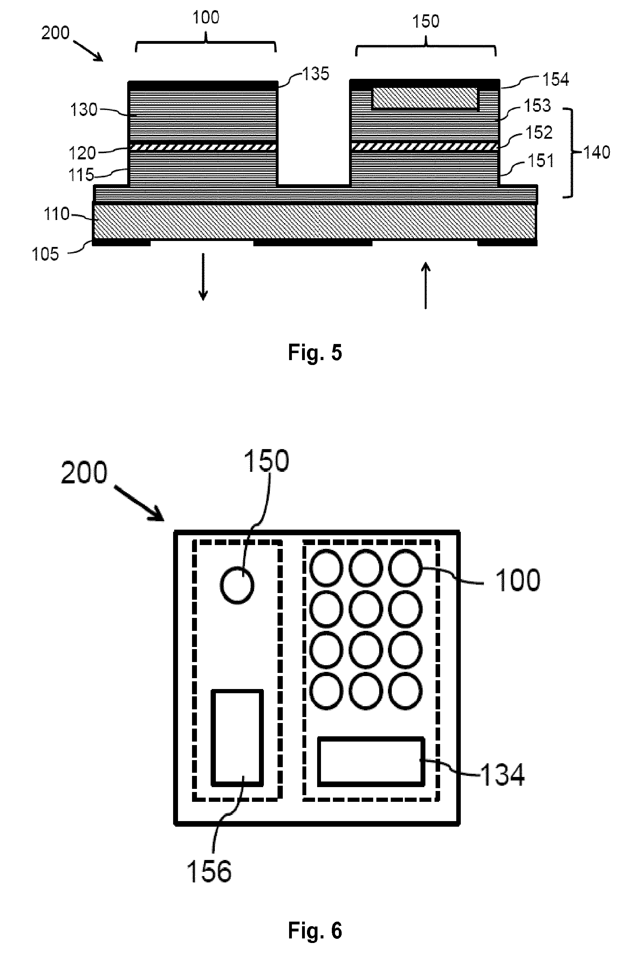

Fig. 5 shows a principal sketch of a top view of a fifth sensor chip 200. The fifth sensor chip 200 comprises a substrate 110. A first electrode 105 is provided or deposited and structured on a first side of the substrate 110. A first mirror structure is either directly or indirectly (e.g. intermediate matching layers) provided on a second surface of the substrate 110. The first mirror structure comprises in this embodiment layers of a first laser mirror 115 and a first photodetector mirror 151. The layers are deposited in the same production steps and a part of the layers are separated from each other in a subsequent etching step. The first laser mirror 115 is in this embodiment arranged as laser emission mirror different as the embodiment shown in Fig. 1. On top of the first mirror structure or on intermediate matching layers are, for example, three, four or more quantum well layers provided. A first part of the quantum well layers forms an active laser layer 120 and the second part a first photosensitive layer 152 which are separated from each other in a subsequent etching step. On top of the quantum well layers or on intermediate matching layers is a second mirror structure provided. A first part of the second mirror structure forms a second laser mirror 130 which is characterized by a higher reflectivity as the reflectivity of the first laser mirror 115. A second part of the second mirror structure forms a second photodetector mirror 153. The second laser mirror 130 and the second photodetector mirror 153 are separated from each other in a subsequent etching step. The first photodetector mirror 151, the first photosensitive layer 152 and the second photodetector mirror 153 define the filter structure 140 and in this embodiment a photodetector structure 150. The first laser mirror 115, the active laser layer 120 and the second laser mirror 130 define a laser cavity of a laser structure 100. The laser structure 100 is arranged in this case as bottom emitting VCSEL. Laser light is emitted via the substrate 110 which is transparent at the emission wavelength. The common first electrode 105 is removed underneath the laser structure 100 and the photodetector structure 150. Laser light generated by means of the laser structure 100 can therefore leave the substrate 110. Reflected laser light can pass the substrate 110 and can be detected by means of the photodetector structure 150. The laser structure 100 further comprises a second laser contact 135 which is provided or deposited on top of the second mirror structure. The photodetector structure 150 comprises a second photodetector electrode 154 which is also provided or deposited on top of the second mirror structure. The laser structure 100 comprises a first mesa and the photodetector structure 150 comprises a second mesa both are etched within the same etching step or steps. At least parts of layers of the second mirror structure which comprises second photodetector mirror 153 are removed such that a reflectivity of the second photodetector mirror 153 is lower than a reflectivity of the second laser mirror 130. A quality factor of the resonant filter structure 140 is therefore lower than a quality factor of the laser cavity. A cavity resulting from removing the at least parts of layers of the second mirror structure maybe filled up, for example, by a plastic material. Alternatively, complete layers of the second mirror structure which comprises second photodetector mirror 153 maybe removed. The second photodetector electrode 154 main in this case cover the whole top layer of the second photodetector mirror 153.

In an alternative approach it may also be possible to provide all electrodes on one side of the substrate 110 as, for example, described with respect to Fig. 4. The levels of the electrodes may in this case be adapted in order to enable, for example, flip chip mounting. Alternatively, special flip chip techniques maybe used in order to enable mounting and especially contacting of electrical contacts which are arranged at different levels.

The substrate 110 maybe at least partially removed if too much light is absorbed by the substrate 110.

The laser cavity comprises in the bottom emitting configuration as discussed with respect to Fig. 5 a first laser mirror, a second laser mirror 130 and an active laser layer 120 embedded between the first laser mirror 115 and the second laser mirror 130, wherein the first laser mirror 115 is arranged as the laser emission mirror, and wherein the at least one photodetector structure 150 comprises a first photodetector mirror 151, a second photodetector mirror 153 and a first photosensitive layer 152 embedded between the first photodetector mirror 151 and the second photodetector mirror 153, wherein the at least one laser structure 100 comprises a first electrical contact 105 and a second laser contact 135, and wherein the at least one photodetector structure 150 comprises a first photodetector electrode 158 and a second or third photodetector electrode 154, 159. The optical passband of the photodetector structure 150 is increased by decreasing the quality factor of the resonant structure comprising the first photodetector mirror 151, the photosensitive layer 152 and the second photodetector mirror 153. The latter may, for example, be done by decreasing a reflectivity of the first photodetector mirror 151 in comparison to a reflectivity of the first laser mirror 115 and/or by decreasing a reflectivity of the second photodetector mirror 153 in comparison to a reflectivity of the second laser mirror 130. Most of the technical measures described with respect to the top emitting embodiments shown in Fig. 2-4 can also be applied in a bottom emitting laser structure 100 as described in Fig. 5.

Fig. 6 shows a principal sketch of a top view of a sixth sensor chip 200. The sixth sensor chip 200 comprises an array of 3x4 laser structures 100 which can be contacted by means of a common first electrical contact 105 (not shown) and a laser contact pad 134. The fifth sensor chip 200 further comprises one nearby photodetector structure 150 which can be electrically connected by means of the common first electrical contact 105 and a photodetector contact pad 156. The photodetector structure 150 is arranged to determine a time t1 of emission of laser light by means of the array of lasers structures 100.

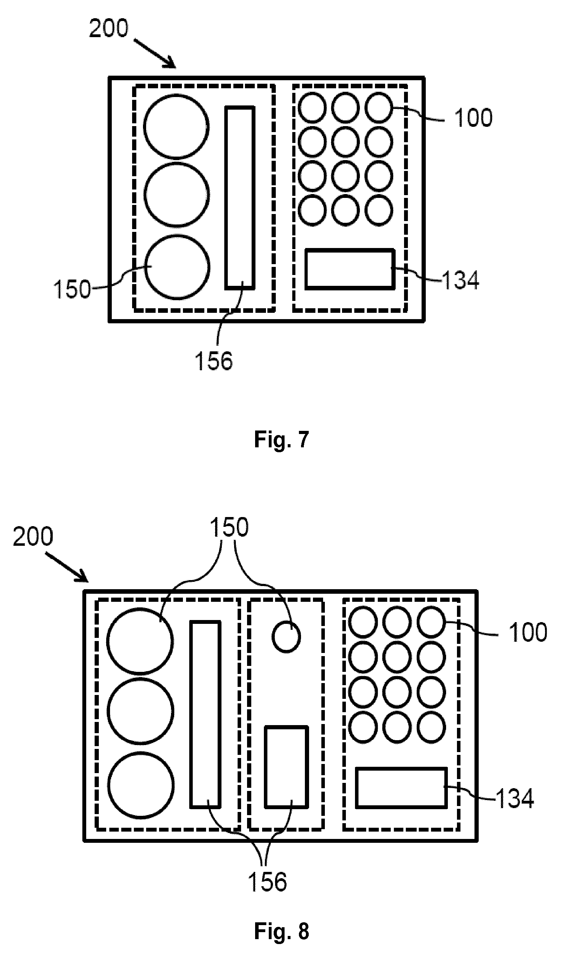

Fig. 7 shows a principal sketch of a top view of a seventh sensor chip 200. The seventh sensor chip 200 comprises an array of 3x4 laser structures 100 which can be contacted by means of a common first electrical contact 105 (not shown) and a laser contact pad 134. The sixth sensor chip 200 further comprises three photodetector structures 150 which can be electrically connected by means of the common first electrical contact 105 and a photodetector contact pad 156. The photodetector structures 150 comprise three mesas with a three times bigger diameter as the mesas of the 12 laser structures 100. The sum of laser light emitting areas of the laser structures 100 is smaller than the sum of laser light receiving areas of the photodetector structures 150. The photodetector structures 150 are arranged to determine a time t2 of receiving laser light emitted by means of the array of lasers structures 100 which is reflected at an external object in order to determine the distance to the object. An optical device which is combined with such a sixth sensor chip 200 has to be arranged such that only laser light which was reflected at the object can be received by the photodetector structures 150.

Fig. 8 shows a principal sketch of a top view of an eigth sensor chip 200. The eigth sensor chip 200 is a combination of the fifth sensor chip 200 shown in Fig. 6 and the sixth sensor chip 200 shown in Fig. 7. Two different photodetector structures 150 are provided. The first photodetector structure 150 is arranged as discussed with respect to Fig. 6. One small photodetector structure 150 is arranged to determine time t1 of emission of laser light by means of the array of lasers structures 100. The second photodetector structures 150 are arranged as discussed with respect to Fig. 7. The three rather big photodetector structures 150 are arranged to determine a time t2 by receiving laser light emitted by means of the array of lasers structures 100 which is reflected at an external object in order to determine the distance to the object. An optical device which is combined with such an eigth sensor chip 200 has to be arranged such that only laser light which was reflected at the object can be received by means of the rather big second photodetector structures 150 wherein the small single first photodetector structure 150 receives laser light emitted by at least one of the laser structures 100 shortly after emission of the laser light.

The number, form and size of laser structures 100, first and second photodetector structures 150 as discussed with respect to Fig. 6, Fig. 7 and Fig. 8 can be varied in a wide range. There maybe, for example, only one laser structure 100 and a multitude of second photodetector structures 150 for detecting t2.

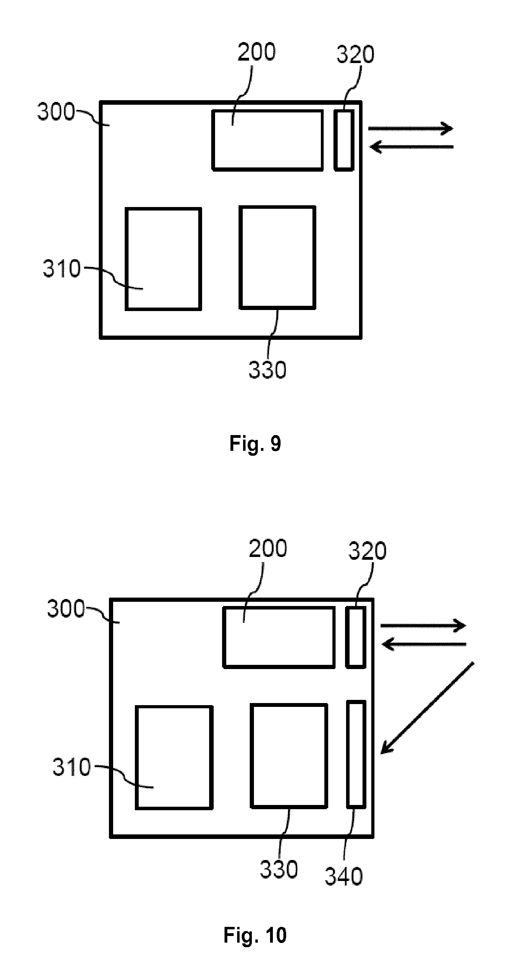

Fig. 9 shows a principal sketch of a first sensor module 300. The sensor module 300 comprises one sensor chip 200 as described in Fig. 7 and the corresponding description. The sensor module 300 further comprises a laser driving circuit 310, a photodetector circuit 330 and an optical device 320. The laser driving circuit 310 is arranged to electrically drive the laser structures 100. The photodetector circuit 330 is arranged to electrically drive the photodetector structures 150. The optical device 320 is arranged to transmit laser light emitted by the laser structures 100 to an object. The time of flight is in this case be determined by means of the driving signal provided by the laser driving circuit 310, which provides a measure for t1, and the measurement signal provided by means of the photodetector structures 150, which provide a measure for t2.

Fig. 10 shows a principal sketch of a second sensor module 300. The sensor module 300 comprises one sensor chip 200 as described in Fig. 6 and the corresponding description. The sensor module 300 further comprises a laser driving circuit 310, a photodetector circuit 330 and an optical device 320. The laser driving circuit 310 is arranged to electrically drive the laser structures 100. The photodetector circuit 330 is arranged to electrically drive the photodetector structure 150. The optical device 320 is arranged to transmit laser light emitted by the laser structures 100 to an object and to reflect a first part of the laser light emitted by the laser structures 100 back to the photodetector structure 150. The sensor module 300 further comprises a separate photodetector 340. The separate photodetector 340 is arranged to receive at least a second part of the laser light emitted by the at least one laser structure 100, wherein the second part of the laser light is reflected by the object. Time t1 is determined by means of the photodetector structure 150 comprised by the sensor chip 200. Time t2 is determined by means of the separate photodetector 340. An analyzer (not shown) may be used to determine the time of flight of laser light reflected at the object.

In an alternative approach it may also be possible to use an optically "separated" photodetector on the same chip in order to detect t2 as discussed with respect to Fig. 8 and the corresponding description instead of the separate photodetector 340.

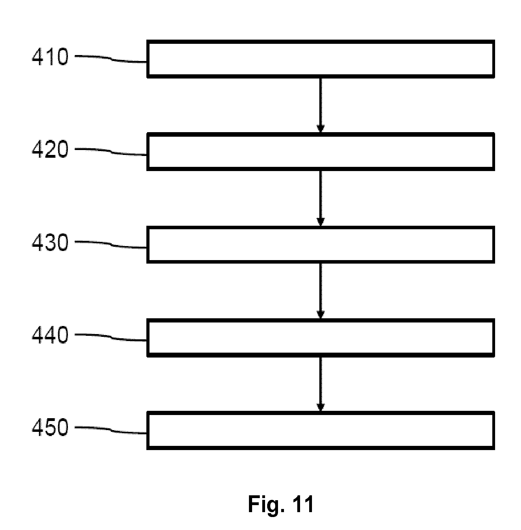

Fig. 11 shows a principal sketch of a method of fabricating or manufacturing a sensor chip 200. In step 410 is a first electrical contact 105 provided. A substrate 110 is provided in step 420. In step 430 is at least one laser structure 100 provided on the substrate 110, wherein the at least one laser structure 100 comprises a laser cavity with a laser emission mirror for emitting laser light. The at least one photodetector structure 150 is provided on the substrate 110 adjacent to the at least one laser structure 100 in step 440. The at least one photodetector structure 150 comprises a photodetector layer for detecting laser light, and wherein the at least one photodetector structure 150 comprises a filter structure 140 for receiving reflected laser light. A first optical passband of the filter structure 140 is adapted in step 450, such that the first optical passband comprises a broader wavelength range as a second optical passband of the laser emission mirror of the laser structure 100. The first optical passband comprises the emission wavelength of the at least one laser structure 100.

It is the intention of the present invention to provide a sensor chip 200 which is especially suited for time-of-flight measurements. The sensor chip 200 comprises one or more lasers and photodetectors which are arranged next to each other on the same semiconductor substrate. The lasers or laser structures 100 and photodetectors or photodetector structures 150 are processed on the same wafer in the same processing steps. Variations between the structures of the lasers and photodetectors can therefore be minimized. The resonant photodetectors are arranged to be sensitive in the wavelength range in which the lasers emit laser light. The optical passband of the resonant photodetectors is broader than the optical passband of a laser cavity of the lasers. Variations of the emission wavelengths of the laser light which may, for example, be caused by temperature differences between the light emitting laser and the resonant photodetectors can therefore be compensated. The common production of the photodetectors and the lasers enables a good match of the passband of the resonant photodetectors and the emission wavelengths of the lasers. Spectral selectivity of the photodetectors can therefore be high in comparison to systems where lasers and photodetectors are produced by means of different processing technologies.

While the invention has been illustrated and described in detail in the drawings and the foregoing description, such illustration and description are to be considered illustrative or exemplary and not restrictive.

From reading the present disclosure, other modifications will be apparent to persons skilled in the art. Such modifications may involve other features which are already known in the art and which may be used instead of or in addition to features already described herein.

Variations to the disclosed embodiments can be understood and effected by those skilled in the art, from a study of the drawings, the disclosure and the appended claims. In the claims, the word "comprising" does not exclude other elements or steps, and the indefinite article "a" or "an" does not exclude a plurality of elements or steps. The mere fact that certain measures are recited in mutually different dependent claims does not indicate that a combination of these measures cannot be used to advantage.

Any reference signs in the claims should not be construed as limiting the scope thereof.

### List of reference numerals:

- 100: laser structure
- 105: first electrical contact
- 110: substrate
- 112: trench
- 115: first laser mirror
- 120: active laser layer
- 130: second laser mirror
- 134: laser contact pad
- 135: second laser contact
- 140: filter structure
- 150: photodetector structure
- 151: first photodetector mirror
- 152: first photosensitive layer
- 153: second photodetector mirror
- 154: second photodetector electrode
- 155: third photodetector mirror
- 156: photodetector contact pad
- 157: second photosensitive layer
- 158: first photodetector electrode
- 159: third photodetector electrode
- 200: sensor chip
- 300: sensor module
- 310: laser driving circuit
- 320: optical device
- 330: photodetector circuit
- 340: separate photodetector
- 410: step of providing a first electrical contact
- 420: step of providing a substrate
- 430: step of providing at least one laser structure
- 440: step of providing at least one photodetector structure
- 450: step of adapting first optical passband

## Claims

1. A sensor chip (200) comprising a semiconductor layer structure, wherein the semiconductor layer structure comprises at least one laser structure (100) deposited on a substrate (110), wherein the semiconductor layer structure further comprises at least one photodetector structure (150) deposited on the substrate (110) adjacent to the at least one laser structure (100), wherein the at least one laser structure (100) comprises a laser cavity with a laser emission mirror for emitting laser light, wherein the at least one photodetector structure (150) comprises a photodetector layer for detecting at least a part of the emitted laser light, and wherein the at least one photodetector structure (150) comprises a filter structure (140), wherein the filter structure (140) comprises a first optical passband comprising an emission wavelength of the laser structure, and wherein the first optical passband comprises a broader wavelength range as a second optical passband of the laser cavity of the at least one laser structure (100).

2. The sensor chip (200) according to claim 1, wherein the laser cavity comprises a first laser mirror (115), a second laser mirror (130) and an active laser layer (120) embedded between the first laser mirror (115) and the second laser mirror (130), wherein the second laser mirror (130) is arranged as the laser emission mirror, and wherein the at least one photodetector structure (150) comprises a first photodetector mirror (151), a second photodetector mirror (153) and a first photosensitive layer (152) embedded between the first photodetector mirror (151) and the second photodetector mirror (153), wherein the at least one laser structure (100) comprises a first electrical contact (105) and a second laser contact (135), and wherein the at least one photodetector structure (150) comprises a first photodetector electrode (158) and a second or third photodetector electrode (154, 159).

3. The sensor chip (200) according to claim 2, wherein the filter structure (140) comprises the first photodetector mirror (151), the first photosensitive layer (152) and the second photodetector mirror (153), wherein a reflectivity of the second photodetector mirror (153) is reduced in comparison to a reflectivity of the laser emission mirror, and wherein the first photosensitive layer (152) is arranged as the photodetector layer.

4. The sensor chip (200) according to claim 2, wherein the second photodetector mirror (153) is **characterized by** a layer sequence which is the same as the a layer sequence of the laser emission mirror, wherein the photodetector structure (150) further comprises a second photosensitive layer (157) and a third photodetector mirror (155) which is embedded between the second photodetector mirror (153) and the third photodetector mirror (155), and wherein the third photodetector electrode (159) faces a second surface of the third photodetector mirror (155), wherein the second surface of the third photodetector mirror (155) is averted from the second photosensitive layer (157), wherein the second photosensitive layer (157) is arranged as the photodetector layer, and wherein the filter structure (140) comprises the second photodetector mirror (153), the second photosensitive layer (157) and the third photodetector mirror (155).

5. The sensor chip (200) according to claim 3, wherein the reflectivity of the second photodetector mirror (153) is reduced by providing at least one additional layer in comparison to the laser emission mirror.

6. The sensor chip (200) according to claim 3, wherein the reflectivity of the second photodetector mirror (153) is reduced by removing at least a part of a layer in comparison to the laser emission mirror.

7. The sensor chip (200) according to any one of claims 1 to 6, wherein the sensor chip comprises two, three, four or more photodetector structures (150), and wherein at least a part of the photodetector structures (150) are arranged such that a detection of laser light emitted by the at least one laser structure (100) and reaching the photodetector structure directly at the time of emission is inhibited.

8. The sensor chip (200) according to claim 1, wherein the sensor chip (200) comprises two, three, four or more laser structures (100), wherein the sensor chip (200) comprises two, three, four or more photodetector structures (150), and wherein a sum of laser light emitting areas of the laser structures (100) is smaller than a sum of laser light receiving areas of the photodetector structures (150).

9. The sensor chip (200) according to any one of claims 1 to 6, wherein the photodetector layer comprises a photosensitive GaAs or GaInNAs layer with a thickness of at least 5 nm, more preferably with a thickness of at least 15 nm and most preferably with a thickness of at least 30 nm.

10. A sensor module (300) comprising at least one sensor chip (200) according to any one of the preceding claims, wherein the sensor module (300) further comprises a laser driving circuit (310), a photodetector circuit (330) and an optical device (320), wherein the laser driving circuit (310) is arranged to electrically drive the at least one laser structure (100), wherein the photodetector circuit (330) is arranged to electrically drive the at least one photodetector structure (150), and wherein the optical device (320) is arranged to transmit laser light emitted by the at least one laser structure (100) to an object.

11. The sensor module (300) according to claim 10, wherein the at least one photodetector structure (150) comprises a first photodetector electrode, a second photodetector electrode (154) and a third photodetector electrode (159), wherein photodetector circuit (330) is arranged to receive a first photo current between the first photodetector electrode and the second photodetector electrode (154), wherein the photodetector circuit (330) is further arranged to receive a second photo current between the second photodetector electrode (154) and the third photodetector electrode (159), and wherein the photodetector circuit (330) is arranged to amplify a difference between the second photo current and the first photo current.

12. The sensor module (300) according to claim 10, wherein the sensor module (300) is arranged to reflect at least a first part of the laser light emitted by the at least one laser structure (100) to the at least one photodetector structure (150) such that a time of emission of the laser light emitted by the at least one laser structure (100) can be detected by means of the at least one photodetector structure (150).

13. The sensor module (300) according to claim 12, wherein the sensor module (300) further comprises a separate photodetector (340), wherein the separate photodetector (340) is arranged to receive at least a second part of the laser light emitted by the at least one laser structure (100), wherein the second part of the laser light is reflected by the object.

14. The sensor module (300) according to 13, wherein the sensor module (300) further comprises an analyzer, wherein the analyzer is arranged to determine a distance to the object based on first measurement signals detected by the at least one photodetector structure (150) and second measurement signals detected by the separate photodetector (340).

15. A method of fabricating a sensor chip (200), the method comprising the steps of:
- providing a first electrical contact (105),
- providing a substrate (110),
- providing a at least one laser structure (100) on the substrate (110), wherein the at least one laser structure (100) comprises a laser cavity with a laser emission mirror for emitting laser light,
- providing at least one photodetector structure (150) on the substrate (110) adjacent to the at least one laser structure (100), wherein the at least one photodetector structure (150) comprises a photodetector layer for detecting laser light, and wherein the at least one photodetector structure (150) comprises a filter structure (140) for receiving reflected laser light,
- adapting a first optical passband of the filter structure (140), such that the first optical passband comprises a broader wavelength range as a second optical passband of the laser emission mirror of the laser structure (100), wherein the first optical passband comprises the emission wavelength of the at least one laser structure (100).
